(19) Europäisches Patentamt

European Patent Office

Office européen des brevets

(11) **EP 1 722 014 A1**

(12) **EUROPEAN PATENT APPLICATION**

(43) Date of publication:
**15.11.2006 Bulletin 2006/46**

(51) Int Cl.:
**C30B 15/12** (2006.01)   **C30B 15/30** (2006.01)
**C30B 15/04** (2006.01)

(21) Application number: **06008308.6**

(22) Date of filing: **21.04.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **10.05.2005 JP 2005136813**

(71) Applicant: **SUMCO Corporation**
**Minato-ku**
**Tokyo (JP)**

(72) Inventors:
- **Furukawa, Jun**
  **Sumco Corporation**
  **Tokyo (JP)**
- **Harada, Kazuhiro**
  **Sumco Corporation**
  **Tokyo (JP)**

(74) Representative: **Albrecht, Thomas**
**Kraus & Weisert,**
**Thomas-Wimmer-Ring 15**
**80539 München (DE)**

(54) **Method for manufacturing nitrogen-doped silicon single crystal**

(57)     There is provided an improvement in a method for manufacturing a silicon single crystal in which nitrogen is doped at a rate which is not smaller than $1 \times 10^{15}$ atoms/cm$^3$ and less than $4.5 \times 10^{15}$ atoms/cm$^3$ by pulling up a silicon single crystal 29 from a silicon melt 12 which is stored in a quartz crucible 13 and contains nitrogen, and its characteristic constitution lies in that the single crystal is pulled up while supplying a silicon raw material 23 which does not contain nitrogen into the silicon melt 12 in such a manner that a liquid level position of the silicon melt stored in the quartz crucible is maintained constant in accordance with an amount of growth of the single crystal. An amount of nitrogen contained in a pulled-up silicon single crystal is controlled, and hence a nitrogen concentration can be uniformed along an axial direction of the single crystal. A pull-up length of the silicon single crystal in which nitrogen is doped at a high concentration can be increased.

EP 1 722 014 A1

**Description**

BACKGROUND OF THE INVENTION

1. Field of the Invention

The present invention relates to a method for manufacturing a silicon single crystal in which nitrogen is doped based on a Czochralski method (which will be referred to as a CZ method hereinafter).

2. Description of the Related Art

In the CZ method, polycrystal silicon is molten in a crucible formed of amorphous quartz glass, and a seed crystal which has been brought into contact with a silicon melt upper surface is pulled up while gently rotating. The silicon melt which has come into contact with the seed crystal loses its heat through the seed crystal, is crystalized in accordance with a crystal orientation of the seed crystal when solidified on the seed crystal, and pulled up as a silicon single crystal. In the CZ method, therefore, a part of the quartz glass of the crucible which comes into contact with the silicon melt is unavoidably molten in the silicon melt, whereby oxygen is blended in the melt. Therefore, the silicon single crystal grown by the CZ method has oxygen as the greatest impurity. $10^{17}$ to $10^{18}$ atoms/cm$^3$ of oxygen is included as an impurity in the silicon single crystal grown by the CZ method.

The impurity oxygen seriously affects mechanical strength, a defect induced by a heat treatment and internal gettering of a silicon wafer obtained by slicing the silicon single crystal. The silicon single crystal grown by the CZ method is mainly used for manufacturing an IC device because of superiority in mechanical strength obtained by this impurity oxygen. This is based on an inherent dislocation securing function of oxygen. However, there is a phenomenon of suddenly becoming weak against a thermal stress when the impurity oxygen in the silicon single crystal is separated out. As a factor of this phenomenon, there can be considered that an interstitial oxygen concentration which brings the dislocation securing function is reduced or that an oxygen precipitate servers as a stress concentration source to facilitate occurrence of dislocation.

Furthermore, crystal originated particles (which will be referred to as COPs hereinafter) are also generated on a surface of the wafer cut out from the silicon single crystal. Here, as to the COP, when a mirror-polished silicon wafer is cleaned by using a mixture of ammonia and hydrogen peroxide, a pit is formed on the wafer surface. When this wafer is measured by using a particle counter, the pit is also a defect caused due to an original particle as well as a crystal detected as a particle. This COP can be a factor which deteriorates electrical characteristics, e.g., a time dependent dielectric breakdown (TDDB), a time zero dielectric breakdown (TZDB) and others of an oxide film. Moreover, when the COP exists on the wafer surface, a step is generated in a device wiring process, which can be a factor of disconnection. Additionally, it can cause leak or the like at an element isolation part, thereby reducing a production yield.

As a method of solving the above-described problems, there is disclosed a method for manufacturing a silicon single crystal by which a nitride is mixed in a polycrystal silicon melt and nitrogen atoms are added in a single crystal (see, e.g., Patent Document 1). According to this method, occurrence of a crystal defect is sufficiently suppressed in a wafer cut out from the grown silicon single crystal. Further, this wafer has resistance to a thermal stress in a semiconductor element manufacturing process and has a small nitrogen doping amount, and hence it does not affect various electrical characteristics of a semiconductor element.

As methods of doping nitrogen in a silicon single crystal, there are (1) a method which puts polycrystal silicon in which a nitrogen compound is mixed or polycrystal silicon having a silicon nitride film formed thereon into a quartz crucible and pulls up a silicon single crystal from a silicon melt containing nitrogen, (2) a method which grows a single crystal while allowing nitrogen or a nitrogen compound gas to flow into a pull-up furnace, (3) a method which sprays nitrogen or a nitrogen compound gas toward a raw material at a high temperature before melting, (4) a method which uses a crucible formed of a nitride, and others.

Patent Document 1 : Japanese Unexamined Patent Application Publication No. S60(1985)-251190 (page 1, lines 5 to 10, and page 3, a right column, lines 2 to 8)

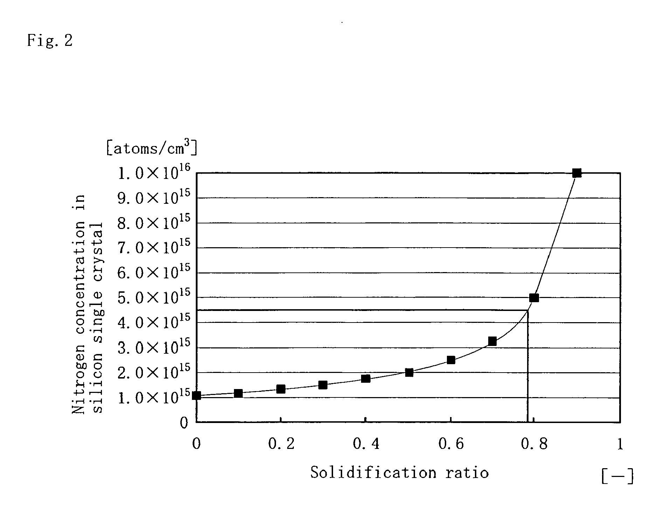

However, in the methods (1) and (3), as a silicon melt amount is reduced with growth of the silicon single crystal, an amount of nitrogen contained in the melt also varies. Therefore, there is a problem that nitrogen cannot be uniformly doped in the grown silicon single crystal. In case of pulling up the silicon single crystal from the silicon melt containing nitrogen at a predetermined concentration, when the silicon single crystal of 200 mm is pulled upward so that a nitrogen concentration of a crystal top becomes $1 \times 10^{15}$ atoms/cm$^3$, the concentration of nitrogen contained in the silicon single crystal is increased as a solidification ratio becomes high as shown in FIG. 2. Polycrystallization is carried out beyond $4.5 \times 10^{15}$ atoms/cm$^3$ which is a solid solubility limit of nitrogen before the solidification ratio reaches 0.8. Therefore, a pull-up length is determined when manufacturing the silicon single crystal containing nitrogen at a high nitrogen concentration which is substantially $10^{15}$ atoms/cm$^3$. In the method (2), it is hard to control a flow quantity of nitrogen or the nitrogen compound gas, and a nitrogen doping amount may be possibly increased in the vicinity of a surface of the pulled-up silicon single crystal. In the method (4), since an amount of nitrogen which is molten in the melt is increased, silicon nitride ($Si_3N_4$) is separated out, and this precipitate may fall into the melt to become a factor of an impurity.

Furthermore, it is known that nitrogen has a very small segregation coefficient and a concentration of doped nitrogen greatly differs depending on a top portion and a bottom portion of the pulled-up silicon single crystal. Therefore, in case of pulling up the silicon single crystal in which nitrogen is doped at a high concentration of approximately $1 \times 10^{15}$ atoms/cm$^3$ at the top portion, the nitrogen concentration in the silicon single crystal is increased as a pulling-up position comes close to the bottom portion, and dislocation occurs beyond a solid solubility limit of nitrogen. Therefore, there is a problem that a pull-up length with which growth is enabled is limited.

BRIEF SUMMARY OF THE INVENTION

It is an object of the present invention to provide a method for manufacturing a silicon single crystal, which can control an amount of nitrogen contained in a pulled-up silicon single crystal and uniform a nitrogen concentration along an axial direction of the single crystal.

It is another object of the present invention to provide a method for manufacturing a silicon single crystal, which can increase a pull-up length of a silicon single crystal in which nitrogen is doped at a high concentration.

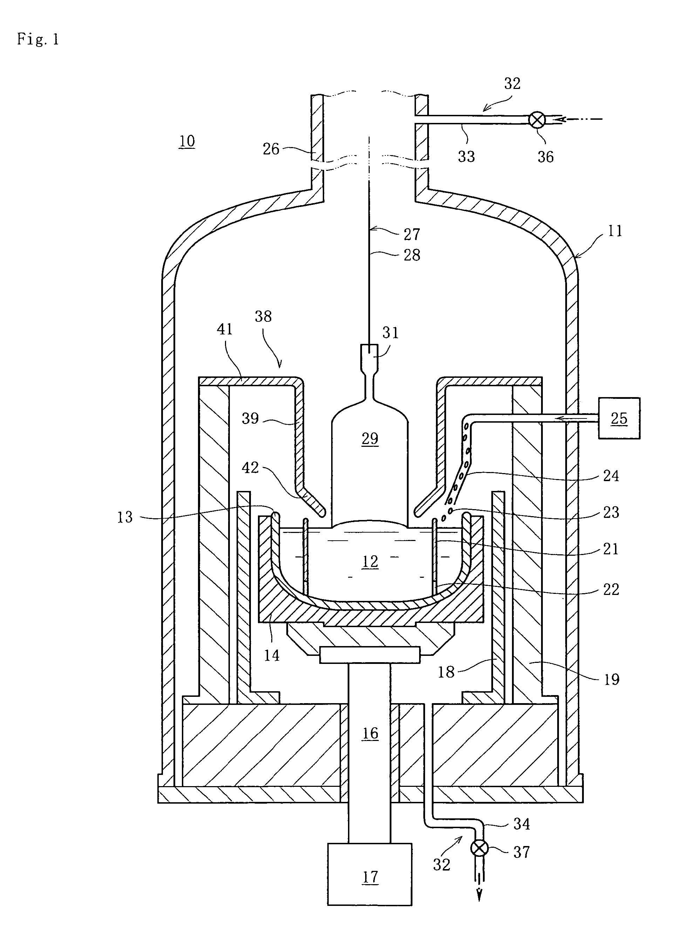

According to the invention defined in claim 1, as shown in FIG. 1, there is provided an improvement in a method for manufacturing a silicon single crystal obtained by pulling up a silicon single crystal 29 from a silicon melt 12 containing nitrogen stored in a quartz crucible 13 and doping nitrogen at a rate which is not smaller than $1 \times 10^{15}$ atoms/cm$^3$ and less than $4.5 \times 10^{15}$ atoms/cm$^3$, and the characteristic constitution thereof lies in that the silicon single crystal is pulled up while supplying a silicon raw material 23 which does not contain nitrogen into the silicon melt 12 in such a manner that a liquid level position of the silicon melt 12 stored in the quartz crucible 13 is maintained constant in accordance with a growth amount of the single crystal.

In the invention defined in claim 1, the silicon single crystal 29 is pulled up while supplying the silicon raw material 23 which does not contain nitrogen into the silicon melt 12 containing nitrogen in such a manner that a liquid level position of the silicon melt 12 stored in the quartz crucible 13 is maintained constant in accordance with a growth amount of the single crystal. According to this method, an increase in a nitrogen concentration in the silicon melt 12 due to a segregation phenomenon of nitrogen generated by puling up the single crystal can be suppressed while additionally supplying the silicon raw material 23, thereby growing the silicon single crystal having a uniform nitrogen concentration region in an axial direction.

According to the invention defined in claim 2, in the invention set forth in claim 1, there is provided the manufacturing method, wherein the silicon raw material 23 which is supplied and does not contain nitrogen is grained silicon or a silicon melt.

According to the invention defined in claim 3, there is provided an improvement in a method for manufacturing a silicon single crystal obtained by pulling up a silicon single crystal 29 from a silicon melt 12 containing nitrogen stored in a quartz crucible 13 and doping nitrogen at a rate which is not smaller than $1 \times 10^{15}$ atoms/cm$^3$ and less than $4.5 \times 10^{15}$ atoms/cm$^3$, and the characteristic constitution thereof lies in that the method comprises in the mentioned order the steps of: pulling up the single crystal 29 while continuously supplying the silicon raw material 23 which does not contain nitrogen into the silicon melt 12 containing nitrogen without moving up and down the quartz crucible 13 in such a manner that a liquid level position of the silicon melt 12 stored in the quartz crucible 13 is maintained constant in accordance with a growth amount of the silicon single crystal 29; and stopping supply of the silicon raw material 23 and then pulling up the single crystal 29 while moving up the quartz crucible 13 in such a manner that a liquid level position of the silicon melt 12 is maintained constant.

In the invention defined in claim 3, an increase in a nitrogen concentration in the silicon melt 12 due to a segregation phenomenon of nitrogen caused by pulling up the silicon single crystal 29 is suppressed while supplying the silicon raw material 23 into the silicon melt 12, thereby growing the silicon single crystal having a uniform nitrogen concentration region along an axial direction. Additionally, after supply of the silicon raw material is stopped, the silicon single crystal is pulled up by a regular method in succession to the above-described step, and hence a pull-up length of the silicon single crystal in which nitrogen is doped at a high concentration can be greatly increased as compared with a pull-up length of a silicon single crystal according to a prior art.

According to the invention defined in claim 4, in the invention set forth in claim 3, there is provided the manufacturing method, wherein the silicon raw material 23 which is supplied and does not contain nitrogen is grained silicon or a silicon melt.

As described above, according to the present invention, there is provided an improvement in a method for manufacturing a silicon single crystal in which nitrogen is doped at a rate which is not smaller than $1 \times 10^{15}$ atoms/cm$^3$ and less than $4.5 \times 10^{15}$ atoms/cm$^3$ by pulling up the silicon single crystal from a silicon melt containing nitrogen stored in a quartz crucible, and its characteristic structure lies in that the silicon single crystal is pulled up while supplying a silicon raw material which does not contain nitrogen into the silicon melt in such a manner that a liquid level position of the silicon melt stored in the quartz crucible is maintained constant in accordance with a growth amount of the single crystal.

According to this method, an increase in nitrogen concentration in the silicon melt due to a segregation phenomenon of nitrogen caused by pulling up the single crystal can be suppressed while additionally supplying the silicon raw material, thereby growing the silicon single crystal having a uniform nitrogen concentration region in an axial direction.

BRIEF DESCRIPTION OF THE DRAWINGS

FIG. 1 is a block diagram showing a pull-up apparatus for a silicon single crystal which is used in a manufacturing method according to the present invention; and
FIG. 2 is a view showing a nitrogen concentration and a solidification ratio of a silicon single crystal pulled up from a silicon melt containing nitrogen.

DETAILED DESCRIPTION OF THE PREFERRED EMBODIMENT

FIG. 1 shows a pull-up apparatus 10 used in a method for manufacturing a silicon single crystal according to the present invention. A quartz crucible 13 which stores a silicon melt 12 therein is provided in a chamber 11 of this pull-up apparatus 10, and an outer peripheral surface of this quartz crucible 13 is covered with a graphite susceptor 14. A lower surface of the quartz crucible 13 is fixed at an upper end of a spindle 16 through the graphite susceptor 14, and a lower portion of this spindle 16 is connected with crucible driving means 17. Although not shown, the crucible driving means 17 has a first rotation motor which rotates the quartz crucible 13 and an elevation motor which moves up and down the quartz crucible 13. Therefore, the quartz crucible 13 can rotate in a predetermined direction and move in a vertical direction by these motors. The outer peripheral surface of the quartz crucible 13 is surrounded by a heater 18 with a predetermined gap therebetween, and this heater 18 is surrounded by a heat-retention cylinder 19. The heater 18 heats/melts a high-purity silicon polycrystal material which is put into the quartz crucible 13 and contains nitrogen, thereby providing a silicon melt 12 containing nitrogen.

A partition ring 21 having substantially the same height as an internal height of the crucible 13 is cylindrically provided in the quartz crucible 13 with a fixed gap between itself and a crucible inner wall surface. A bottom portion of the partition ring 21 is secured on an upper bottom surface of the crucible 13 and configured to partition the inside of the quartz crucible 13 into an inner region at a central part and an outer region at a peripheral part. A communicating portion 22 is formed at a side wall lower portion of the partition ring 21 so that the inner region and the outer region partitioned by the partition ring 21 can communicate with each other through the communicating portion 22. The communicating portion 22 may be, e.g., a hole or a slit piercing the side wall portion, and its shape is not restricted as long as the inner region and the outer region can communicate with each other through this portion. A base end of a supply tube 24 is arranged at a melt upper portion of the outer region with a gap between itself and a melt liquid level. The supply tube 24 pierces the chamber 11, and the other end of the supply tube 24 is connected with storing means 25 provided outside the chamber. A silicon raw material 23 which does not contain nitrogen is stored in the storing means 25. The silicon raw material 23 is configured to be supplied from the outer region of the quartz crucible 13 through the supply tube 24. As the silicon raw material 23, there is grained silicon or a silicon melt. This silicon raw material 23 may contain a dopant such as P or B. Incidentally, in case of using the silicon melt as the silicon raw material 23, a non-illustrated small quartz crucible having a heater may be provided above the quart crucible 13 in the chamber 11 without using the supply tube 24 and the storing means 25, the silicon melt may be stored in this small quartz crucible, and the silicon melt may be dropped and supplied into the outer region of the quartz crucible 13.

Furthermore, a cylindrical casing 26 is connected with an upper end of the chamber 11. Pull-up means 27 is provided to this casing 26. The pull-up means 27 has a pull-up head (not shown) horizontally provided at an upper end portion of the casing 26 so as to be capable of turning, a second rotation motor (not shown) which rotates this head, a wire cable 28 which hangs down from the head to the rotation center of the quartz crucible 13, and a pull-up motor (not shown) which is provided in the head and reels in or out the wire cable 28. A seed crystal 31 which is dipped into the silicon melt 12 to pull up a silicon single crystal ingot 29 is attached at a lower end of the wire cable 28.

Moreover, gas supplying/discharging means 32 which supplies an inert gas from the upper side of the chamber 11 and discharges the inert gas from the lower side of the chamber 11 is connected with the chamber 11. The gas supplying/discharging means 32 has a supply pipe 33 having one end connected with a peripheral wall of the casing 26 and the other end connected with a tank (not shown) which stores the inert gas, and a discharge pipe 34 having one end connected with a lower wall of the chamber 11 and the other end connected a vacuum pump (not shown). First and second flow regulating valves 36 and 37 which adjust a flow quantity of the inert gas flowing through the supply pipe 33 and the discharge pipe 34 are respectively provided to these pipes 33 and 34.

A heat shielding member 38 which surrounds an outer peripheral surface of the ingot 29 is provided between the outer peripheral surface of the ingot 29 and the inner peripheral surface of the quartz crucible 13. This heat shielding member 38 is formed into a cylindrical shape and has a cylindrical portion 39 which prevents radiant heat from the heater 18 and a flange portion 41 which is provided to be continuous with an upper edge of this cylindrical portion 39 and bulge in a substantially horizontal direction. When the flange portion 41 is mounted on the heat-retention cylinder 19, the heat shielding member 38 is fixed in the chamber 11 in such a manner that a lower edge of the cylindrical portion 39 is positioned above a surface of the silicon melt 12 with a predetermined distance therebetween. The cylindrical portion 39 in this embodiment is a cylindrical body having the same diameter, and a bulge portion 42 which bulges in a direction of the inside of the cylinder is provided at a lower part of this cylindrical portion 39. Each of the cylindrical portion 39 and the bulge portion 42 is formed of C (graphite), graphite having SiC coated on a surface thereof, or the like.

A manufacturing method using the thus configured manufacturing apparatus of a silicon single crystal will now be described.

According to the method for manufacturing a silicon single crystal of the present invention, the seed crystal 31 is dipped in an inner region of the silicon melt 12 which is stored in the quartz crucible 13 and contains nitride, and the seed crystal 31 is pulled upward at a predetermined speed, thereby manufacturing the silicon single crystal 29 in which nitrogen is doped at a rate which is not smaller than $1 \times 10^{15}$ atoms/cm$^3$ and less than $4.5 \times 10^{15}$ atoms/cm$^3$. A characteristic structure of the present invention lies in that the single crystal 29 is pulled upward while supplying the silicon raw material 23 which does not contain nitrogen into the silicon millet 12 containing nitrogen in such a manner that a liquid level position of the silicon melt 12 stored in the quartz crucible 13 is maintained constant in accordance with a growth amount of the single crystal. Based on this method, an increase in nitrogen concentration in the silicon melt 12 due to a segregation phenomenon of nitrogen caused by pulling up the single crystal can be suppressed while additionally supplying the silicon raw material 23, thereby growing the silicon single crystal having a uniform nitrogen concentration region in an axial direction.

A concentration of nitrogen contained in the silicon single crystal to be pulled up and a concentration of nitrogen contained in the silicon melt have a relationship represented by the flowing Expression (1) under given fixed conditions:

$$[C]_s \;=\; k_0[C]_0(1-L)^{k_0-1} \qquad \ldots \; (1)$$

In Expression (1), $[C]_s$ is a concentration of nitrogen in the crystal, $[C]_0$ is an initial concentration of nitrogen in the silicon melt, $k_0$ is a segregation coefficient, and the segregation coefficient of nitrogen is $7 \times 10^{-4}$, and L is a solidification ratio.

Since the solidification ratio L in Expression (1) is zero immediately after the silicon single crystal is pulled up, a nitrogen concentration of $1 \times 10^{15}$ atoms/cm$^3$ at the top portion of the silicon single crystal can be achieved by controlling a nitrogen concentration in the silicon melt to approximately $1.43 \times 10^{18}$ atoms/cm$^3$. It is to be noted that the silicon single crystal in which a concentration of nitrogen in the top portion does not reach $1 \times 10^{15}$ atoms/cm$^3$ immediately after the upward pulling operation is formed if a concentration of nitrogen contained in the silicon melt is less than $1.43 \times 10^{18}$ atoms/cm$^3$. As methods of allowing nitrogen to be contained in the silicon melt, there are (1) the above-described method of putting polycrystal silicon in which a nitrogen compound is mixed or polycrystal silicon having a silicon nitride film formed therein into the quartz crucible and pulling up the silicon single crystal from the silicon melt containing nitrogen, (3) a method of spraying nitrogen or a nitrogen compound gas to a raw material at a high temperature before melting, and others. However, the present invention is not restricted to these methods.

It is preferable for the method for manufacturing a nitrogen-doped silicon single crystal according to the present invention to include a step of pulling up the single crystal 29 while continuously supplying the silicon raw material 23 which does not contain nitrogen into the silicon melt 12 containing nitrogen without moving up and down the quartz crucible 13 in such a manner that a liquid level position of the silicon melt 12 stored in the quartz crucible 13 is maintained constant in accordance with an amount of growth of the silicon single crystal, and a step of pulling up the single crystal 29 while moving up the quartz crucible 13 in such a manner that a liquid level position of the silicon melt 12 is maintained constant after stopping supply of the silicon raw material 23 in the mentioned order. According to the above-described method, since an increase in concentration of nitrogen in the silicon melt 12 due to a segregation phenomenon of nitrogen caused by pulling up the silicon single crystal 29 is suppressed while supplying the silicon raw material 23 into the silicon melt 12, the silicon single crystal having a uniform nitrogen concentration region in an axial direction can be grown. Further, after supply of the silicon raw material 23 is stopped, the silicon single crystal is pulled up by the regular method in succession to the above-mentioned steps. Therefore, a pull-up length of the silicon single crystal in which nitrogen is doped at a high concentration can be greatly increased as compared with a pull-up length of the silicon single crystal which is pulled up by the conventional method.

EXAMPLE

An example according to the present invention as well as a comparative example will now be described in detail.

<Example 1>

80 kg of a silicon melt containing nitrogen at a rate of $1.43 \times 10^{15}$ atoms/cm$^3$ was stored in a quartz crucible. Furthermore, 80 kg of a silicon raw material which does not contain nitrogen was prepared. Then, a seed crystal was dipped in the silicon melt, and this seed crystal was pulled upward while gently rotating to start growth of a silicon single crystal having a diameter of 8 inches (approximately 200 mm). The silicon raw material which does not contain nitrogen was continuously supplied into the silicon melt without moving up and down the quartz crucible in such a manner that a liquid level position of the silicon melt stored in the quartz crucible is maintained constant in accordance with an amount of growth of the single crystal until 80 kg of the silicon single crystal is grown. Subsequently, after stopping supply of the silicon raw material, the silicon single crystal was grown while moving up the quartz crucible in such a manner that a liquid level position of the silicon melt is maintained constant, and the upward pulling operation was stopped when 4.5 $\times 10^{15}$ atoms/cm$^3$ which is a solid solubility limit of nitrogen was achieved.

<Comparative Example 1>

160 kg of a silicon melt which contains nitrogen at a rate of $1.43 \times 10^{15}$ atoms/cm$^3$ was stored in a quartz crucible. A seed crystal was dipped in the silicon melt, and this seed crystal was pulled upward while gently rotating to start growth of a silicon single crystal having a diameter of 8 inches (approximately 200 mm). The silicon single crystal was grown while moving up the quartz crucible in such a manner that a liquid level position of the silicon melt is maintained constant, and the upward pulling operation was stopped when $4.5 \times 10^{15}$ atoms/cm$^3$ which is a solid solubility limit of nitrogen was achieved.

<Comparative Test 1>

In the method of Comparative Example 1, $4.5 \times 10^{15}$ atoms/cm$^3$ which is a solid solubility limit of nitrogen was achieved in the vicinity of 1650 mm as a pull-up length to perform polycrystallization. A solidification ratio L of the silicon single crystal with respect to the silicon melt used in the example was 0.78. In upward pulling of the silicon single crystal based on the CZ method, a neck portion and a shoulder portion are formed, and then a base portion which is utilized as a product is formed. Therefore, approximately 1550 to 1600 mm excluding the neck portion and the shoulder portion in an entire pull-up length is grown as the base portion.

On the other hand, in the method of Example 1, $4.5 \times 10^{15}$ atoms/cm$^3$ which is a solid solubility limit of nitrogen was achieved in the vicinity of 1900 mm as a pull-up length to perform polycrystallization. A solidification ratio L of the silicon single crystal with respect to the silicon melt and the silicon raw material used in the example was 0.89. Therefore, approximately 1800 to 1850 mm excluding the neck portion and the shoulder portion in an entire pull-up length was grown as the base portion. Furthermore, in the method of Example 1, in a region grown as the base portion, approximately 1100 mm as a crystal length was provided as a uniform nitrogen concentration region of approximately $1 \times 10^{15}$ atoms/cm$^3$. Moreover, in the method of Example 1, an amount of nitrogen added to the silicon melt stored in the quartz crucible before upward pulling was reduced to approximately 1/2 as compared with Comparative Example 1.

**Claims**

1. A method for manufacturing a nitrogen-doped silicon single crystal in which nitrogen is doped at a rate which is not smaller than $1 \times 10^{15}$ atoms/cm$^3$ and less than $4.5 \times 10^{15}$ atoms/cm$^3$ by pulling up a silicon single crystal (29) from a silicon melt (12) which is stored in a quartz crucible (13) and contains nitrogen, comprising the step of:

   pulling up the single crystal (29) while supplying a silicon raw material (23) which does not contain nitrogen into the silicon melt (12) in such a manner that a liquid level position of the silicon melt (12) stored in the quartz crucible (13) is maintained constant in accordance with an amount of growth of the single crystal.

2. The method according to claim 1, wherein the supplied silicon raw material (23) which does not contain nitrogen is grained silicon or a silicon melt.

3. A method for manufacturing a nitrogen-doped silicon single crystal in which nitrogen is doped at a rate which is not

smaller than $1 \times 10^{15}$ atoms/cm$^3$ and less than $4.5 \times 10^{15}$ atoms/cm$^3$ by pulling up a silicon single crystal (29) from a silicon melt (12) which is stored in a quartz crucible (13) and contains nitrogen, comprising in the mentioned order the steps of:

pulling up the single crystal (29) while continuously supplying the silicon raw material (23) which does not contain nitrogen into the silicon melt (12) containing nitrogen without moving up and down the quartz crucible (13) in such a manner that a liquid level position of the silicon melt (12) stored in the quartz crucible (13) is maintained constant in accordance with an amount of growth of the silicon single crystal (29); and

pulling up the single crystal (29) while moving up the quartz crucible (13) in such a manner that the liquid level position of the silicon melt (12) is maintained constant after stopping supply of the silicon raw material (23).

4. The method according to claim 3, wherein the supplied silicon raw material (23) which does not contain nitrogen is grained silicon or a silicon melt.

Fig. 1

Fig. 2

**European Patent Office**

**EUROPEAN SEARCH REPORT**

Application Number

EP 06 00 8308

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 555 010 A (SHIN-ETSU HANDOTAI COMPANY LIMITED) 11 August 1993 (1993-08-11) * column 1, line 13 - column 2, line 2 * | 1-4 | INV. C30B15/12 C30B15/30 C30B15/04 |
| A | EP 1 215 309 A (KOMATSU DENSHI KINZOKU KABUSHIKI KAISHA) 19 June 2002 (2002-06-19) * paragraphs [0018], [0033], [0037], [0038] * | 1-4 | |
| A | YATSURUGI Y ET AL: "CONCENTRATION, SOLUBILITY, AND EQUILIBRIUM DISTRIBUTION COEFFICIENT OF NITROGEN AND OXYGEN IN SEMICONDUCTOR SILICON" APPLIED COMPUTATIONAL ELECTROMAGNETICS SOCIETY JOURNAL, THE SOCIETY, MONTEREY, CA,, US, vol. 120, no. 7, July 1973 (1973-07), pages 975-979, XP008026050 ISSN: 1054-4887 * the whole document * | 1-4 | |

TECHNICAL FIELDS SEARCHED (IPC)

C30B

The present search report has been drawn up for all claims

| Place of search | Date of completion of the search | Examiner |
|---|---|---|
| Munich | 8 June 2006 | Brisson, O |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 1 722 014 A1**

This annex lists the patent family members relating to the patent documents cited in the above-mentioned European search report.
The members are as contained in the European Patent Office EDP file on
The European Patent Office is in no way liable for these particulars which are merely given for the purpose of information.

08-06-2006

| Patent document cited in search report | | Publication date | Patent family member(s) | | Publication date |
|---|---|---|---|---|---|
| EP 0555010 | A | 11-08-1993 | DE | 69301035 D1 | 01-02-1996 |
| | | | DE | 69301035 T2 | 02-05-1996 |
| | | | JP | 2506525 B2 | 12-06-1996 |
| | | | JP | 5208889 A | 20-08-1993 |
| | | | US | 5340434 A | 23-08-1994 |
| EP 1215309 | A | 19-06-2002 | WO | 0116409 A1 | 08-03-2001 |
| | | | US | 6800132 B1 | 05-10-2004 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP S601985251190 A